(19) Europäisches Patentamt
European Patent Office
Office européen des brevets

(11) Veröffentlichungsnummer: **0 160 257 B1**

(12) **EUROPÄISCHE PATENTSCHRIFT**

(45) Veröffentlichungstag der Patentschrift: **08.05.91**

(51) Int. Cl.[5]: **C08F 218/04**, C08F 8/12, C09J 123/00

(21) Anmeldenummer: **85104828.0**

(22) Anmeldetag: **20.04.85**

(54) **Fluorhaltige Copolymerisate, Verfahren zu ihrer Herstellung und ihre Verwendung.**

(30) Priorität: **28.04.84 DE 3415975**

(43) Veröffentlichungstag der Anmeldung:
**06.11.85 Patentblatt 85/45**

(45) Bekanntmachung des Hinweises auf die Patenterteilung:
**08.05.91 Patentblatt 91/19**

(84) Benannte Vertragsstaaten:
**AT BE CH DE FR GB IT LI NL SE**

(56) Entgegenhaltungen:
**EP-A- 0 040 841**
**EP-A- 0 086 406**
**GB-A- 596 943**
**US-A- 4 322 511**

(73) Patentinhaber: **HOECHST AKTIENGESELLSCHAFT**
**Postfach 80 03 20**
**W-6230 Frankfurt am Main 80(DE)**

(72) Erfinder: **Graun, Karl, Dr.**
**An der Obermühle 14**
**W-6108 Weiterstadt(DE)**
Erfinder: **Rauterkus, Karl Josef, Dr.**
**Im Hain 2**
**W-6233 Kelkheim (Taunus)(DE)**

EP 0 160 257 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft fluorhaltige Copolymerisate enthaltend als Monomereinheiten Vinylester, die gegebenenfalls teilweise oder vollständig zu Vinylalkoholeinheiten verseift sind, fluorhaltige ethylenisch ungesättigte Verbindungen, gegebenenfalls ethylenisch ungesättigte Mono- und/oder Dicarbonsäuren und gegebenenfalls weitere copolymerisationsfähige Verbindungen, wobei die fluorhaltigen Monomereinheiten in den Copolymerisaten seitenkettenständige Fluorcarbongruppen enthalten, die aus mindestens 2 benachbarten und F-C-Bindungen aufweisenden C-Atomen bestehen, Verfahren zur Herstellung der Copolymerisate und ihre Verwendung auf verschiedenen Einsatzgebieten.

Aus der US-PS 30 69 388 ist bereits bekannt, 3,3,3-Trifluorpropen und Vinylacetat nach üblichen Verfahren, wie Lösungs-, Emulsions- oder Masseverfahren, bei 20 - 80 °C mit radikalisch wirkenden Katalysatoren bei. Überdruck oder autogenem Druck zu copolymerisieren.

In der GB-PS 5 96 943 ist ferner die Mischpolymerisation von Trifluorchlorethylen mit Vinylacetat sowie die anschließende Hydrolyse des Copolymerisats zu den entsprechenden Alkoholen beschrieben. Die erhaltenen Produkte sind vulkanisierbar. Aus der US-PS 28 91 934 ist die Copolymerisation von 1-Chlor-2,2-difluorethylen mit Vinylacetat bekannt. Die Verseifung der Copolymerisate zu modifizierten Polyvinylalkoholen ist nicht erwähnt. Die Copolymerisate finden Verwendung für Überzüge, Lackierungen, Klebstoffe und Filme.

Die Herstellung eines thermoreversiblen Gels ist in der US-PS 24 99 097 beschrieben. Es wird erhalten durch Mischpolymerisation von Vinylfluorid mit Vinylacetat und Verseifung des Mischpolymerisats. Die Herstellung erfolgt als Dispersion.

In Europ. Polymer Journal 3 (1967) Nr. 1, Seiten 5 - 12 ist die Copolymerisation von Vinylacetat mit Tetrafluorethylen bei 50 °C beschrieben. Die Copolymerisate lassen sich durch alkalische Hydrolyse in die entsprechenden fluorhaltigen, copolymeren Polyvinylalkohole überführen.

Diese Produkte können bis zu ca. 20 Gew.-% Fluor enthalten, welches unmittelbar an die die Hauptketten der Polymermoleküle bildenden C-Atome gebunden ist.

Aus der EP-Offenlegungsschrift 40 841 sind photosensitive fluorhaltige Polymerisate bekannt, die insbesondere zur Herstellung von Offset-Druckplatten eingesetzt werden und Comonomereinheiten mit fotosensitiven Gruppen enthalten.

Aus der EP-Offenlegungsschrift 86 406 sowie aus der japanischen Patentanmeldung 81 0 1184 sind Copolymerisate aus Vinylestern, Ethylen und Fluoralkylacrylaten bekannt. Die Copolymerisate werden in Dispersionsform erhalten. Die Möglichkeit ihrer Verseifung zu modifizierten Polyvinylalkoholen ist nicht erwähnt.

Der vorliegenden Erfindung lag nun die Aufgabe zugrunde, Polymerisate mit verbesserten Eigenschaften verfügbar zu machen, die vielseitig verwendbar sind und nicht die Nachteile der vorstehend genannten bekannten fluorhaltigen Copolymerisate besitzen. Eine weitere Aufgabe wurde darin gesehen, insbesondere Copolymerisate zu finden, die sich zu copolymeren modifizierten Polyvinylalkoholen mit verbesserter Dispergierfähigkeit verseifen lassen.

Die Lösung der gestellten Aufgabe konnte überraschenderweise durch Copolymerisation von Vinylestern mit fluorhaltigen, ethylenisch ungesättigten Monomeren sowie gegebenenfalls zusätzlich ethylenisch ungesättigten Mono- und/oder Dicarbonsäuren und gegebenenfalls zusätzlich weiteren copolymerisationsfähigen Monomeren gefunden werden, wobei solche fluorhaltigen Monomeren eingesetzt werden, deren copolymerisationsfähige Ethylengruppe durch Fluorcarbongruppen enthaltende Reste substituiert ist und die Fluorcarbongruppen aus mindestens 2 benachbarten, F-C-Bindungen aufweisenden C-Atomen bestehen, so daß die fluorhaltigen Monomereinheiten in den Copolymerisaten seitenkettenständige Fluorcarbongruppen enthalten, die aus mindestens 2 benachbarten und F-C-Bindungen aufweisenden C-Atomen bestehen.

Der Anteil an erfindungsgemäßen fluorhaltigen Comonomeren beträgt vorzugsweise 0,05 bis 60 Gew.-%, bezogen auf die eingesetzte Gesamtmonomerenmenge.

Gegenstand der Erfindung sind daher fluorhaltige Copolymerisate, hergestellt durch radikalisch initiierte Copolymerisation von ethylenisch ungesättigten copolymerisationsfähigen Monomeren, enthaltend als Monomereinheiten Vinylester, fluorhaltige ethylenisch ungesättigte Monomere, gegebenenfalls ethylenisch ungesättigte Mono- und/oder Dicarbonsäuren und gegebenenfalls weitere Monomere, wobei gegebenenfalls die Vinylestereinheiten teilweise oder vollständig zu Vinylalkoholeinheiten verseift sind, dadurch gekennzeichnet, daß sie fluorhaltige Copolymerisate der Formel I,

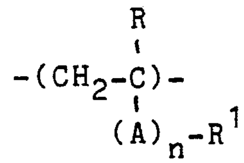 (I)

worin
R = H, $-CH_3$, $-CF_3$,
A = $-CH_2-$, -O-, $-CH_2-O-(CH_2)_m-$,

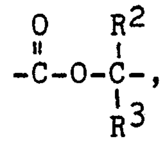

wobei $R^2$ und $R^3$, die gleich oder verschieden sein können, für H, $(C_1-C_4)$-Alkyl, $-CF_3$ oder $R^1$ stehen,
n = 0 - 1, m = 0 - 2,
$R^1$ = $-C_pF_{2p+1}$, $-C_pF_{2p}X$, $-C_pF_{2p-1}XH$, die linear oder verzweigt sein können,
p = 2 - 20, vorzugsweise 6 - 12, und X = Halogen
bedeutet, entsprechen, bei Zugrundelegung von fluorhaltigen Ausgangsmonomeren der Formel Ia,

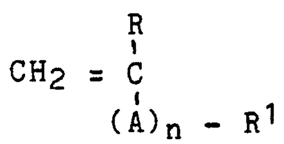 (Ia)

in der R, $R^1$, A und n die Bedeutung wie in Formel I haben.

Unter den Vinylestern in den erfindungsgemäßen fluorhaltigen Copolymerisaten ist, wenn eine Verseifung erfolgen soll, Vinylacetat bevorzugt.

Unter den in den erfindungsgemäßen fluorhaltigen Copolymerisaten gegebenenfalls enthaltenen Mono- und/oder Dicarbonsäureeinheiten sind diejenigen der Formel II,

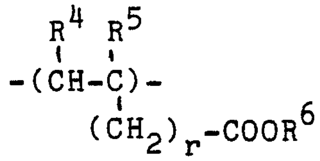 (II)

worin
$R^4$ = H, -COOH, $(C_1-C_5)$-Alkyl,
$R^5$ = H, $-CH_3$, -COOH, wobei $R^4$ und $R^5$ gleich oder verschieden sein können,
r = 0 - 5,
$R^6$ = H, $NH_4$, Na, K, Li
bedeutet, bevorzugt, bei Zugrundelegung von monomeren Ausgangscarbonsäuren der Formel IIa,

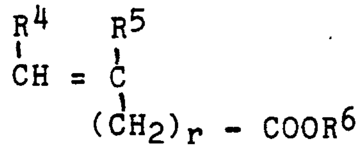 (IIa)

in der $R^4$, $R^5$, $R^6$ und r die Bedeutung wie in Formel II haben.

Bei den erfindungsgemäßen verseiften fluorhaltigen Copolymerisaten sind diejenigen bevorzugt, welche einen Verseifungsgrad ihrer Vinylestereinheiten zu Vinylalkoholeinheiten von 40 bis 100 Mol-%, vorzugsweise 60 bis 99 Mol-%, insbesondere 70 bis 98 Mol-%, aufweisen.

Weiterer Gegenstand der Erfindung ist ein Verfahren zur Herstellung der vorstehend beschriebenen erfindungsgemäßen fluorhaltigen Copolymerisate durch radikalisch initiierte Copolymerisation von copolymerisationsfähigen Vinylestern mit fluorhaltigen ethylenisch ungesättigten Monomeren, gegebenenfalls ethylenisch ungesättigten Mono- und/oder Dicarbonsäuren und gegebenenfalls weiteren Monomeren sowie gegebenenfalls nachfolgender teilweiser oder vollständiger Verseifung der Vinylestereinheiten zu Vinylalkoholeinheiten, dadurch gekennzeichnet, daß zur Copolymerisation vorzugsweise 0,05 bis 60 Gew.-%, bezogen auf die eingesetzte Gesamtmonomerenmenge, fluorhaltige Monomere, deren copolymerisationsfähige Ethylengruppe durch Fluorcarbongruppen enthaltende Reste substituiert ist, wobei die Fluorcarbongruppen aus mindestens 2 benachbarten und F-C-Bindungen aufweisenden C-Atomen bestehen, eingesetzt werden.

Bevorzugt wird die erfindungsgemäße Copolymerisation in der Masse und/oder in Lösung durchgeführt.

Die gegebenenfalls durchzuführende teilweise oder vollständige Hydrolyse der Vinylestereinheiten zu Vinylalkoholeinheiten in den fluorhaltigen Copolymerisaten erfolgt bevorzugt durch alkalisch katalysierte Alkoholyse nach bekannten Methoden.

Als besonders geeignete Vinylester kommen vor allem die Vinylester gesättigter aliphatischer Carbonsäuren mit 1 - 18, insbesondere 2- 12, C-Atomen zur Anwendung, wie z.B. Vinylformiat, Vinylacetat, Vinylpropionat, Vinylbutyrat, Vinyllaurat, Vinylstearat. Sie können einzeln oder in Mischung miteinander eingesetzt werden. Vorzugsweise wird Vinylacetat verwendet.

Comonomere, die der Struktureinheit der Formel (I) entsprechen, sind z.B. Perfluorhexylethylen, Perfluoroctylethylen, Perfluorpropylvinylether, Allyltetrafluorethylether, Allylhexafluorpropylether, Hexafluorisobuten. Die Verbindungen aus der Reihe der perfluorierten $\alpha$-Olefine können auch in Mischung miteinander eingesetzt werden. Der Perfluorcarbonteil der fluorhaltigen Comonomeren muß sich auf mindestens zwei benachbarte C-Atome erstrecken.

Erfindungsgemäße Copolymerisate werden z.B. erhalten durch Copolymerisation der fluorhaltigen Monomeren mit Vinylestern gesättiger aliphatischer Carbonsäuren in der Masse oder in Emulsion oder Suspension, bevorzugt in Lösung, mit üblichen zur radikalischen Polymerisation geeigneten Initiatoren. Es kann im Batch- oder Zudosierverfahren gearbeitet werden.

Vorzugsweise werden 0,05 - 20 Gew.-%, bezogen auf die Gesamtmonomerenmenge, des fluorhaltigen Comonomeren im Vinylester zusammen mit dem radikalischen Initiator gelöst, in einen Reaktionskolben gegeben und bei 60 - 80 °C 5 - 10 Stunden polymerisiert. Während der Polymerisation kann, ggf. in mehreren Portionen, ein organisches Lösungsmittel hinzugefügt werden.

Als Polymerisationsinitiatoren können z.B. organische Peroxide, wie Benzoylperoxid, t-Butylhydroperoxid, Cumolhydroperoxid, Dibenzoylperoxid, Azo-Verbindungen, wie Azo-di-isobutyronitril, sowie Perester, wie t-Butylper-2-ethylhexanoat, in einer Menge von 0,005 - 0,3 Gew.-%, bezogen auf Vinylester, vorzugsweise 0,05 - 0,25 Gew.-%, eingesetzt werden.

Als organische Lösungsmittel können der Reaktionslösung primäre, sekundäre oder tertiäre aliphatische Alkohole, wie z.B. Methanol, Ethanol oder Isopropanol, bevorzugt Isopropanol und Methanol, besonders bevorzugt Methanol, in einer Menge von 10 - 60 Gew.-%, bezogen auf Vinylester, hinzugefügt werden. Ester, wie Methylacetat, stellen ebenfalls geeignete Lösungsmittel dar.

Die auf diese Weise hergestellten, in alkoholischer Lösung vorliegenden erfindungsgemäßen Copolymerisate können nach Entfernung des organischen Lösungsmittels durch bekannte Trocknungsprozesse in fester Form, vorzugsweise als Granulate, erhalten werden. Bevorzugt werden die Vinylestercopolymerisate durch partielle bzw. vollständige Verseifung der Vinylestereinheiten in die entsprechenden fluorhaltigen Polyvinylalkohole übergeführt.

Die Verseifung der Vinylestercopolymerisate erfolgt vorzugsweise durch Alkoholyse. Diese Alkoholyse wird in Gegenwart eines niederen Alkanols durchgeführt, bevorzugt eines Alkanols mit 1, 2 oder 3 Kohlenstoffatomen, wie z.B. Methanol, Ethanol, Propanol oder Isopropanol; Methanol ist dabei besonders bevorzugt. Es kann im allgemeinen der gleiche Alkohol verwendet werden, der gegebenenfalls auch bei der Copolymerisation zur Gewinnung der Vinylestercopolymerisate anwesend war. Vorzugsweise geht man von der bei der Copolymerisation gegebenenfalls erhaltenen alkoholischen Lösung aus. Zur Durchführung der Alkholyse wird das Alkanol in einer Menge von 10 - 50 Gew.-%, vorzugsweise 20 - 40 Gew.-%, bezogen auf das Vinylestercopolymerisat, eingesetzt.

Das Alkoholyse-Verfahren wird in Gegenwart eines basischen Katalysators ausgeführt. Als Katalysator kann vorzugsweise ein Alkalihydroxid oder Alkalialkoholat verwendet werden. Geeignete Katalysatoren sind beispielsweise Natriumhydroxid, Kaliumhydroxid, $NH_3$, Natriummethylat, -ethylat und -propylat, ferner

Kaliummethylat, -ethylat und -propylat. Der basische Katalysator wird in Form einer Lösung verwendet, wobei ein Alkanol der vorgenannten Art als Lösungsmittel dient. Die Menge einer beispielsweise 10 gew.-%igen Lösung des Katalysators in Alkanol beträgt üblicherweise 0,1 - 10 Gew.-%, vorzugsweise 0,4 - 3 Gew.-%, bezogen auf den Vinylesteranteil in dem Copolymerisat. Die Konzentration des Katalysators in der verwendeten alkoholischen Katalysatorlösung liegt allgemein zweckmäßigerweise im Bereich von 5 - 25 Gew.-%, vorzugsweise 8 - 20 Gew.-%. Zur Verseifung bzw. Alkoholyse des Vinylestercopolymerisats wird letzteres in einem niederen Alkanol bei einer Temperatur von 10 - 80 °C, vorzugsweise 20 - 60 °C, insbesondere Raumtemperatur, gelöst. Der homogenen Vinylestercopolymerisatlösung werden bei einer Temperatur von 10 - 40 °C, vorzugsweise 20 - 30 °C, entsprechend dem einzustellenden Hydrolysegrad, bestimmte Mengen an Katalysatorlösung zugesetzt und intensiv verrührt bzw. gemischt.

Die Umesterungsreaktion setzt sofort nach Zugabe der alkoholischen Katalysatorlösung ein. Je nach Art und Menge des Vinylestercopolymerisats wird für die Umesterung eine Zeitspanne von 1 - 130 Minuten, vorzugsweise 30 - 90 Minuten, inbesondere 40 - 80 Minuten, benötigt.

Das durch die Umesterung gewonnene Vinylalkoholcopolymerisat wird in üblicher Weise neutralisiert, gewaschen und getrocknet. Die Neutralisation erfolgt mit Hilfe einer anorganischen oder vorzugsweise organischen Säure, z.B. Phosphorsäure oder Essigsäure.

Außer der vorstehend beschriebenen Alkoholyse sind jedoch auch andere für Polyvinylester bekannte Verseifungsverfahren auf die erfindungsgemäßen Copolymerisate anwendbar, z.B. die Verseifung in wäßriger Dispersion mit methylalkoholischer oder wäßriger Kalilauge oder mit Hilfe saurer Verseifungsmittel, wie Schwefelsäure oder Chlorwasserstoff.

Die erfindungsgemäßen fluorhaltigen Polyvinylalkohole können wasserlöslich oder bedingt wasserlöslich, wasserquellbar oder wasserunlöslich sein, je nach Gehalt an den einzelnen Comonomeranteilen im Polymerisat.

Der Verseifungsgrad der verseifbaren Struktureinheiten liegt im Bereich von 40 - 100, vorzugsweise 60 - 99, insbesondere 70 - 98 Mol-%.

Die Alkoholyseprodukte bzw. Verseifungsprodukte der erfindungsgemäßen Vinylestercopolymerisate, d.h., die gleichfalls erfindungsgemäßen Vinylalkohol-Copolymerisate, können Verwendung finden als Emulgatoren, Viskositätserhöher, Schutzkolloide oder zur Herstellung von wäßrigen Hydraulikflüssigkeiten sowie als Flutmittelzusatz für die tertiäre Erdölförderung. Sie eignen sich generell zur Herstellung von wäßrigen, hochviskosen Vinylalkoholcopolymerisatlösungen, wogegen die entsprechenden Ausgangsvinylestercopolymerisate in organischen Lösungsmitteln niedrige reduzierte spezifische Viskositäten aufweisen können, d.h., daß sich in den methanolischen Verseifungslösungen hohe Konzentrationen der Ausgangsvinylestercopolymerisate einstellen lassen. Umgekehrt ist es mit den Vinylalkoholcopolymerisaten möglich, entsprechende Viskositäten schon bei niedrigen Lösungskonzentrationen zu erzielen.

Im Gegensatz hierzu weisen die mit wirksamen Mengen Tetrafluorethylen modifizierten bekannten copolymeren Polyvinylacetate in dem Lösungsmittel Ethylacetat eine hohe reduzierte spezifische Viskosität auf, während die wäßrigen Lösungen ihrer Verseifungsprodukte in Abhängigkeit vom Hydrolysegrad teilweise Ausfällungen bzw. homogenes Lösungsverhalten bei Viskositäten, die lediglich im Bereich der bekannten höheren Lösungsviskositäten von unmodifizierten Polyvinylalkoholen liegen, zeigen.

Unter Zusatz von externen Weichmachern sind die partiell hydrolysierten erfindungsgemäßen Vinylestercopolymerisate, welche Terpolymerisate oder Quaterpolymerisate darstellen können, sehr gut zu Folien extrudierbar, die wesentlich geringere Oberflächenstörungen aufweisen als solche aus nicht erfindungsgemäß modifizierten Vinylalkoholpolymerisaten.

Die erfindungsgemäß modifizierten copolymeren Polyvinylalkohole sind ferner für die Papierbeschichtung und als Schlichtemittel geeignet.

Bezüglich des Eigenschaftsspektrums erfindungsgemäßer fluorhaltiger Copolymerisate wurde überraschenderweise gefunden, daß z.B. insbesondere erfindungsgemäße Copolymerisate mit Comonomereinheiten, die perfluorierte aliphatische, lineare oder verzweigte Reste mit bis zu 18, vorzugsweise bis zu 12, insbesondere 6 - 8 C-Atomen enthalten, bereits bei geringen Anteilen an diesen fluorierten Comonomereinheiten im Copolymerisat bei den verseiften Copolymerisaten in Abhängigkeit von diesen fluorierten Comonomeranteilen in wäßrigen Phasen äußerst unterschiedliche und insbesondere unerwartet hohe Lösungsviskositäten aufweisen bzw. erzeugen können. Dabei steigt z.B. bei konstantem Hydrolysegrad mit zunehmendem Anteil an fluorierten Comonomereinheiten die Lösungsviskosität in wäßriger Phase stark an, während die Viskosität des nicht verseiften Ausgangsvinylestercopolymerisats in organischen Lösungsmitteln, gemessen in organischen Lösungsmitteln, wie z.B. Ethylacetat, mit steigendem Anteil an fluorierten Comonomereinheiten abfällt.

Diese überraschenden Eigenschaftsmerkmale lassen sich z.B. überzeugend an Vinylacetat-Perfluoroctylethylen-Copolymerisaten mit Gehalten von ca. 0,1 bis 0,4 Gew.-% Perfluoroctylethyleneinheiten

und den daraus durch Verseifung hergestellten Vinylalkoholcopolymerisaten mit ca. 0,2 bis 0,8 Gew.-% Perfluoroctylethyleneinheiten bei vergleichbaren Verseifungsgraden demonstrieren, indem man die Viskositätszahlen der Ausgangscopolymerisate an 1 gew.-%igen Lösungen in Ethylacetat bei 25 °C im Ostwald-Viskosimeter, und die ihrer Verseifungsprodukte an 4 gew.-%igen wäßrigen Lösungen bei 23 °C im Höppler-Viskosimeter ermittelt und jeweils die Viskositäten der beiden Produktreihen graphisch gegen den prozentualen Gehalt an Perfluoroctyleinheiten aufträgt.

Es wird somit möglich, aus modifizierten Polyvinylacetaten mit niedrigen Lösungsviskositäten modifizierte Polyvinylalkohole mit unerwartet höheren Lösungsviskositäten herzustellen. Aus Gründen der Verarbeitbarkeit stellt dies einen erheblichen technischen Vorteil dar. Weiterhin zeigen die aus wäßriger Phase erhaltenen Filme der erfindungsgemäßen fluorierten copolymeren Polyvinylalkohole schon bei geringen Gehalten an fluorierten Comonomereinheiten, vergleichsweise zu unmodifiziertem Polyvinylalkohol sowie auch vergleichsweise zu durch Tetrafluorethyleneinheiten modifizierten Polyvinylalkohol, ein deutlich hydrophobes Verhalten.

Überraschenderweise wurde außerdem gefunden, daß die erfindungsgemäßen fluorierten copolymeren Polyvinylalkohole hervorragende Emulgiereigenschaften aufweisen.

Zu diesem Zweck sind Emulsionen bereitet worden, und es wurde das Auftreten bzw. Wandern der bei der Destabilisierung der Emulsionen auftretenden Phasengrenze in einem verschlossenen Meßzylinder in Abhängigkeit von der Zeit beobachtet.

Die Emulsionen werden in der Weise hergestellt, daß sie einen Gehalt von 8 Gew.-% erfindungsgemäß modifizierten copolymeren Polyvinylalkohol in einer 50 Gew.-% nichtwäßrige Bestandteile enthaltenden Emulsion aufweisen. Dazu werden in 162 g $H_2O$ 12 g des entsprechenden fluorhaltigen copolymeren Polyvinylalkohols aufgelöst und in dieser Lösung 150 g monomeres Vinylacetat emulgiert.

Zusätzlich werden Vergleichsemulsionen hergestellt, wobei als Emulgator bzw. Schutzkolloid ein üblicher, nicht modifizierter Polyvinylalkohol, der eine Viskosität von 26 cP und einen Hydrolysegrad von 82,6 - 83 Mol-% aufweist bzw. ein Polyvinylalkohol, der 4,1 Gew.-% Comonomereinheiten des Tetrafluorethylens enthält und eine Viskosität von 40,4 mPa•s sowie einen Hydrolysegrad von 85,9 Mol-% aufweist, verwendet wird.

Bei vergleichbaren Viskositäten und Hydrolysegraden zeigt der copolymere Polyvinylalkohol mit Perfluoroctylethylencomonomereinheiten schon bei geringen Anteilen an den genannten Comonomereneinheiten (über die Dauer von 50 Tagen) eine deutlich verbesserte Stabilität der Emulsion. Dieses herausragende Verhalten zeigt sich auch bei erfindungsgemäßen copolymeren Polyvinylalkoholen mit Perfluorhexylethylen oder mit Allyltetrafluorethylether als fluorhaltiges Comonomer.

Die erfindungsgemäßen fluorhaltigen copolymeren Polyvinylalkohole führen zu einer bemerkenswert höheren Stabilität von Emulsionen bzw. weisen eine erhöhte Emulgierfähigkeit auf, vergleichsweise zu bekannten Polyvinylalkoholen bzw. bekannten fluorhaltigen copolymeren Polyvinylalkoholen.

Die Oberflächenspannung von Wasser kann z.B. durch Zusatz von erfindungsgemäßem, fluorhaltigen terpolymerem Polyvinylalkohol im Konzentrationsbereich von 0,05 - 0,6 g/ 100 ml gegenüber reinem Wasser/Luft (T = 20 °C) von 73 dyn/cm auf ca. 45 dyn/cm erniedrigt werden.

Die Erfindung betrifft auch Copolymerisate, die Carboxylgruppen enthalten.

Werden Vinylester, z.B. Vinylacetat, mit z.B. Crotonsäure oder Maleinsäure unter normalen Bedingungen copolymerisiert und die resultierenden Copolymerisate zu den säuremodifizierten copolymeren Polyvinylalkoholen verseift, so erhält man Polyvinylalkohole mit niedriger Viskosität ihrer 4 gew.-%igen wäßrigen Lösung.

Die Viskosität der 10 gew.-%igen wäßrigen Lösung, gemessen bei 85 °C im Rheomat 30 der Fa. Contraves, liegt außerhalb des für Schlichten gewünschten Bereiches von 60 - 120 mPa•s. Die Produkte sind zwar alkalilöslich, was als eine wichtige Voraussetzung für den Einsatz als Schlichtemittel gilt, die erhaltenen Filme sind jedoch spröde.

Es wurde nun überraschenderweise gefunden, daß bei der Copolymerisation unter Einsatz einer dritten copolymerisationsfähigen monomeren Komponente neben Vinylacetat und Crotonsäure, und zwar einer ungesättigten Perfluoralkyl-Verbindung, bei der in copolymerisiertem Zustand die Perfluoralkylkette seitenkettenständig zur Hauptkette steht, aus dem Copolymerisat durch partielle Verseifung ein Ouaterpolymerisat erhalten wird, welches die oben beschriebenen Mängel nicht mehr aufweist.

Überraschend ist weiterhin, daß schon bei geringen erfindungsgemäßen fluorhaltigen Comonomergehalten in dem quaterpolymeren Polymerisat ein deutlicher Effekt hinsichtlich der Viskosität zu beobachten ist.

Man erhält klare Filme, die bei Raumtemperatur und 50 % relativer Luftfeuchte glatt und flexibel sind. Die Wasseraufnahme, gemessen nach einer Laufzeit von 8 Tagen bei 65 % und 85 % relativer Luftfeuchte, bewegt sich zwischen 5 - 40 Gew.-%, vorzugsweise zwischen 8 - 25 Gew.-%.

Die Viskositäten der 10 gew.-%igen wäßrigen Lösung, gemessen bei 85 °C im Rheomat 30 der Fa.

Contraves, können, je nach dem verwendeten Comonomeranteil, einen breiten Bereich von 5 - 180 mPa•s, vorzugsweise 35 - 140 mPa•s, insbesondere 60 - 120 mPa•s, überspannen.

Es ist somit möglich, je nach fluorhaltigem Comonomeranteil, eine gewünschte Viskosität bei einem bestimmten Carboxylgruppengehalt einzustellen. Die Produkte sind somit hervorragend für den Einsatz im Schlichtebereich geeignet. Überraschend ist weiterhin die hohe Viskositätsstabilität über längere Zeit bei höheren Temperaturen, sowie die gute Scherstabilität. Die Produkte sind damit außerdem für den Einsatz in wäßrigen Hydraulikflüssigkeiten geeignet.

Diese erfindungsgemäßen und Carboxylgruppen enthaltenden fluorhaltigen Copolymerisate können im (Masse-) Batch- oder im Dosierverfahren hergestellt werden.

Vorzugsweise kommt das Dosierverfahren zur Anwendung. Als Komponenten können bevorzugt z.B. folgende Comonomeren eingesetzt werden:

A. Vinylester, z.B. Vinylformiat, Vinylacetat, Vinylpropionat, Vinylbutyrat, Vinyllaurat, Vinylstearat sowie Vinylester verzweigter Carbonsäuren mit 10 - 12 C-Atomen. Sie können einzeln oder in Mischung miteinander eingesetzt werden. Vorzugsweise wird Vinylacetat verwendet.

B. Unter den fluorhaltigen Comonomeren sind diejenigen mit langkettigen Perfluoralkylresten bevorzugt gegenüber denen mit kurzkettigen Perfluoralkylresten. Dies ist vor allem für die anwendungstechnischen Eigenschaften der aus den Terpolymerisaten durch Verseifung hergestellten copolymeren Polyvinylalkohole von Bedeutung.

Zum Einsatz kommen daher als fluorierte Comonomere bevorzugt solche mit einem perfluorierten Alkylrest mit 4 - 20, vorzugsweise 5 - 15, insbesondere 6 - 8 C-Atomen. Der perfluorierte Alkylrest kann auch über ein Sauerstoffatom mit der ethylenisch ungesättigten Gruppierung der Verbindung verbunden sein.

Perfluorhexyl- bzw. Perfluoroctylethylen sind besonders bevorzugte fluorhaltige Comonomere.

C. Die Säurekomponente stammt aus der Gruppe der ungesättigten Mono- bzw. Di-carbonsäuren entsprechend der allgemeinen Formel II.

Als $\alpha,\beta$-ungesättigte Monocarbonsäuren sind z.B. zu nennen: Acrylsäure, Methacrylsäure, Crotonsäure, Vinylessigsäure und Allylacetessigsäure.

Auch Dicarbonsäuren (ungesättigte), wie z.B. Malein-, Fumar-, Itacon- oder Citraconsäure können vorteilhaft Verwendung finden.

Während der Polymerisation können dem Reaktionsgemisch Als Verdünnungsmittel noch organische Lösungsmittel zugesetzt werden. Hierbei ist Methanol bzw. Ethanol bevorzugt, besonders aber Methanol.

Die Herstellung dieser erfindungsgemäßen Copolymerisate kann durch einfache radikalische Polymerisation erfolgen, wobei von zwei hergestellten Mischungen eine im Reaktionsgefäß (Mischung I) vorgelegt wird, während man die andere (Mischung II) zudosiert. Die im Reaktionsgefäß vorgelegte Mischung (Mischung I) besteht aus z.B. Vinylacetat und der Gesamtmenge an für höhere Temperaturen geeignetem Initiator.

Die Menge der Mischung I beläuft sich auf etwa 10 Gew.-% der Gesamtmenge an Vinylacetat.

Als Initiatoren für erhöhte Temperaturen von 65 - 90 °C werden z.B. Peroxide, wie Dibenzoylperoxid, besonders bevorzugt. Perester, wie t-Butyl-per-2-ethylhexanoat, werden in einer Menge von 0,01 - 1,0 Gew.-%, bezogen auf Vinylester, bevorzugt 0,1 - 0,6 Gew.-%, eingesetzt.

Die Mischung II setzt sich aus dem verbleibenden Rest Vinylacetat sowie der monomeren Carbonsäure und der monomeren Perfluoralkylverbindung zusammen. Bevorzugt wird als Carbonsäure Crotonsäure in einer Menge von 0,5 - 8 Gew.-%, insbesondere 1 - 6 Gew.-%, vorzugsweise 1,5 - 5 Gew.-%, bezogen auf die Gesamtmischung ohne Initiator, eingesetzt.

Als Perfluoralkylverbindungen sind z.B. die Comonomeren Perfluorhexylethylen und perfluoroctylethylen besonders bevorzugt. In der Gesamtmischung sind sie mit 0,05 - 10 Gew.-%, vorzugsweise mit 0,1 - 5 Gew.-%, insbesondere mit 0,2 - 3 Gew.-%, enthalten.

Zur Polymerisation wird die vorgelegte Mischung I auf 70 - 80 °C aufgeheizt. Beim Einsetzen der Polymerisationsreaktion wird mit der Zudosierung der Mischung II begonnen. Es wird während 1 - 6 Stunden, bevorzugt während 3 Stunden, zudosiert. Die Polymerisationstemperatur wird während dieser Zeit konstant gehalten. Nach Anstieg der Temperatur der Reaktionsmischung um 1 - 5 °C, bevorzugt 1 - 2 °C, wird stufenweise mit einem organischen Lösungsmittel, wie z.B. Methanol, verdünnt. Im weiteren Verlauf der Polymerisation werden zur Umsatzsteigerung zusätzliche Mengen, bevorzugt 0,1 - 0,3 Gew.-%, bezogen auf die Gesamtmonomerenkonzentration, an Initiator, wie z.B. Bis(4-tert.-butylcyclohexyl)-peroxydicarbonat oder Bis-(cyclohexyl)-peroxydicarbonat der Reaktionsmischung zugesetzt. Es wird im Laufe der Polymerisationsreaktion mit weiterem Lösungsmittel verdünnt; am Ende der Reaktion erhält man eine ca. 40 gew.-%ige Lösung.

Auf Grund des geringen Restmonomergehaltes sind diese solchermaßen verdünnten Lösungen direkt

für die Verseifung zum erfindungsgemäßen Quaterpolymerisat einsetzbar.

Die Verseifung bzw. das Alkoholyseverfahren werden in Gegenwart eines basischen Katalysators durchgeführt. Als Katalysator dient vorzugsweise ein Alkalihydroxyd oder Alkalialkoholat. Geeignete Verseifungsmittel sind beispielsweise Natriumhydroxid, Kaliumhydroxid, $NH_3$, Natriummethylat, -ethylat und -propylat sowie Kaliummethylat, -ethylat und -propylat. Der Katalysator wird in Form einer Lösung eingesetzt, wobei bevorzugt ein Alkanol der vorgenannten Art als Lösungsmittel dient. Die Menge einer beispielsweise 10 gew.-%igen Lösung des Katalysators in Alkanol kann üblicherweise 0,1 - 10 Gew.-%, vorzugsweise 0,4 - 3 Gew.-%, bezogen auf den copolymeren Polyvinylesteranteil, betragen. Die Konzentration des Katalysators in der verwendeten alkoholischen Katalysatorlösung liegt im allgemeinen zweckmäßigerweise im Bereich von 5 - 25 Gew.-%, vorzugsweise 8 - 20 Gew.-%.

Zur Einstellung definierter Bedingungen, d.h. eines definierten Hydrolysegrades bei konstanten Rahmenbedingungen, ist es unbedingt erforderlich, mit äquimolaren Mengen an Alkali die Carboxylgruppen der copolymeren Säurekomponenten zu neutralisieren.

Der Verseifungsgrad der verseifbaren Vinylester-Struktureinheiten liegt im Bereich von 40 - 100, vorzugsweise 60 - 99, insbesondere 88 - 98 Mol-%.

Außer den bereits beschriebenen Verwendungen der erfindungsgemäßen fluorhaltigen Copolymerisate seien noch die Verwendungen als Klebstoffkomponenten sowie zur Oberflächenmodifizierung von organischen und/oder anorganischen Substraten, ferner als Bestandteil in photosensitiven Schichten, insbesondere in photosensitiven Druckplatten, sowie als Hilfsmittel bei der tertiären Erdölförderung genannt.

Die Erfindung wird durch die nachstehenden Beispiele näher erläutert.

Beispiel 1

Herstellung eines Vinylestercopolymerisats

In einer 15 1 Reaktionsapparatur mit Rührer, Thermometer und Rückflußkühler werden 3960 g Vinylacetat, versetzt mit 40 g Perfluorhexylethylen und 13,33 g Dibenzoylperoxid (75 gew.-%ig), vorgelegt. Die Reaktionsmischung wird auf 73 °C aufgeheizt. Nach einer Polymerisationsdauer von 50 Min. wird mit 1000 g Methanol auf eine 80 gew.-%ige Mischung verdünnt und bei 60 °C gehalten. Im Laufe der Polymerisation wird stufenweise von 80 gew.-%iger Lösung über 70 %, 60 % auf eine 50 gew.-%ige methanolische Lösung verdünnt. Die Temperatur steigt während der Polymerisation bis auf 65 °C an. Nach 5 Stunden wird die Reaktionslösung mit 2 kg Methanol versetzt und eine Destillation zur Befreiung der Reaktionslösung von monomerem Vinylacetat angeschlossen.

Die Ausbeute beträgt 2834 g an Copolymerisat. Man erhält ein Copolymerisat mit einer reduzierten spezifischen Viskosität von 99,7 ml/g, gemessen an einer Lösung des Copolymerisats der Konzentation c von 1,02 g/100 ml bei 25 °C in Ethylacetat.

Beispiel 2

Herstellung eines Terpolymerisats aus dem Vinylestercopolymerisat des Beispiels 1 durch Verseifung

500 g eines entsprechend Beispiel 1 hergestellten Vinylacetatcopolymerisats werden in 1500 g Methanol gelöst und der Lösung 40 g Wasser sowie 40 g 10 gew.-%ige methanolische Natronlauge bei einer Temperatur von 22 °C hinzugefügt.

Zum Homogenisieren wird die Mischung ca. 5 Minuten gerührt. Im weiteren wird das entstandende alkalische Gel vermahlen und nach 51 Minuten mit 6 ml konzentrierter Essigsäure in 500 g Methanol neutralisiert.

Man erhält ein Vinylalkoholeinheiten enthaltendes Terpolymerisat mit einem Acetylgehalt von 15,4 Gew.-%, entsprechend einem Hydrolysegrad von 81,4 Mol-%.

Das Produkt ist in Wasser nur teilweise löslich.

Beispiel 3

Herstellung eines Vinylestercopolymerisats

Eine Mischung aus 1485 g Vinylacetat, 15 g Perfluorpropylvinylether, 5 g Dibenzoylperoxid (75 gew.-%ig) und 643 g Methanol werden in einen 3 l Autoklaven mit Rührer gefüllt. Das Gemisch wird auf 80 °C aufgeheizt und 5 Stunden bei dieser Temperatur und unter autogenem Druck von 1,5 - 1,8 bar copolymerisiert.

Im Laufe der Polymerisation wird die Lösung von 70 Gew.-% durch Zusatz von Methanol auf 60 Gew.-% verdünnt. Nach Trocknung der Lösung erhält man 1395 g festes Copolymerisat mit einem Gehalt von 0,97 Gew.-% Perfluorpropylvinylethereinheiten. Letzterer Comonomeranteil wurde über eine Fluoranalyse ermittelt.

Beispiel 4

Herstellung eines Terpolymerisats aus dem Vinylestercopolymerisat des Beispiels 3 durch Verseifung

500 g des nach Beispiel 3 hergestellten Copolymerisats werden in 1167 g Methanol aufgelöst. Dieser Lösung werden 40 g $H_2O$ und 40 g 10 gew.-%ige methanolische Natronlauge hinzugefügt und unter Rühren ca. 5 Minuten homogenisiert. Das entstehende feste, alkalische Gel wird vermahlen und nach 47 Minuten mit 6 ml konzentrierter Essigsäure in 500 g Methanol neutralisiert. Das neutralisierte Produkt ward in Methanol gewaschen, anschließend auf einer Nutsche abgesaugt und das Festprodukt im Trockenschrank getrocknet.

Man erhält 256 g eines fluorhaltigen und Vinylalkoholeinheiten enthaltenden Terpolymerisats mit einem Hydrolysegrad von 84,6 Mol-%.

Die Fluoranalyse ergibt einen Anteil an fluorhaltigen Comonomereinheiten von 1,56 Gew.-%, bezogen auf das Terpolymerisat. Die Visklosität der 4 gew.-%igen wäßrigen Lösung des Terpolymerisats beträgt 4,2 mPa•s.

Beispiel 5

Herstellung eines Vinylestercopolymerisats

In einer Reaktionsapparatur entsprechend Beispiel 1 wird eine Mischung aus 3992 g Vinylacetat, 8 g Perfluorhexylethylen und 13,33 g Dibenzoylperoxid (75 gew.-%ig) vorgelegt, auf 75 °C aufgeheizt und 30 Minuten in Masse polymerisiert. Die Mischung wird nach 30 Minuten mit Methanol auf 80 Gew.-% Feststoffgehalt verdünnt. Die Reaktionstemperatur wird bei 62 °C gehalten. Im weiteren Verlauf der Polymerisation wird mit Methanol auf eine 30 gew.-%ige Lösung verdünnt, und nach 5 Stunden werden das Lösungsmittel und die flüchtigen Bestandteile destillativ entfernt. Die Ausbeute beträgt 3178 g Copolymerisat.

Die reduzierte spezifische Viskosität des Copolymerisats beträgt 127,4 ml/g, bei einer Konzentration c von 1,07 g/ 100 ml, gemessen in Ethylacetat bei 25 °C.

Beispiel 6

Herstellung eines Terpolymerisats aus dem Vinylestercopolymerisat des Beispiels 5 durch Verseifung

2240 g einer 25 gew.-%igen methanolischen Lösung des nach Beispiel 5 hergestellten Copolymerisats werden mit 75 g 10 gew.-%iger methanolischer Natronlauge versetzt. Nach Beendigung der Gelphasenreaktion und Vermahlen des Gelproduktes werden dem erhaltenen Granulat Methanol und 11,25 ml konz. Essigsäure zur Neutralisation zugesetzt. Die Verseifungsdauer beträgt 45 Minuten. Es resultiert ein Vinylalkoholeinheiten enthaltendes Terpolymerisat mit einem Hydrolysegrad von 95,8 Mol-%. Aus dessen analytisch bestimmten Fluorgehalt ergibt sich ein Comonomeranteil an Perfluorhexylethyleneinheiten von 0,40 Gew.-%, bezogen auf das Terpolymerisat. Die Höppler-Viskosität der 4 gew.-%igen wäßrigen Lösung

beträgt 26,2 mPa•s.

Beispiel 7

Herstellung eines Vinylestercopolymerisats

Entsprechend Beispiel 1, jedoch in einem 6 l Reaktionskolben mit Rückflußkühler, Thermometer und Rührer, wird eine Copolymerisation mit einer Mischung aus 792 g Vinylacetat und 8 g Perfluoroctylethylen sowie 2,66 g Dibenzoylperoxid durchgeführt.

Der Reaktionsumsatz beläuft sich auf 72,9 Gew.-%, bezogen auf die eingesetzte Gesamtmonomerenmenge.

Dag resultierende Copolymerisat hat eine reduzierte spezifische Viskosität von 102,8 ml/g, gemessen in Ethylacetat bei 25° C.

Beispiel 8

Herstellung einem Terpolymerisats durch Verseifung eines Vinylestercopolymerisats

560 g eines Vinylacetatcopolymerisats mit einem Gehalt von 1 Gew.-% Perfluoroctylethyleneinheiten werden in Methanol gelöst. Man stellt die Lösung auf einen Feststoffgehalt von 25 Gew.-% ein. Diese Lösung wird mit 7 Gew.-% Wasser, bezogen auf das Copolymerisat, und mit 0,7 Gew.-% 10 gew-.%iger methanolischer Natronlauge versetzt.

Die Verseifungstemperatur beträgt 23° C. Nach 60 Minuten wird das entstandene Gel in einer Mühle granuliert und die Verseifungsreaktion durch Zusatz von 5,9 ml Essigsäure in 500 g Methanol gestoppt.

Das resultierende Terpolymerisat hat einen Hydrolysegrad von 85 Mol-% und enthält analytisch bestimmte 2,07 Ge.-% Perfluoroctylethyleneinheiten. Es ist in Wasser nur teilweise löslich und neigt zur Gelbildung.

Beispiel 9

Herstellung eines Vinylestercopolymerisats

16 g Allyltetrafluorethylether, 784 g Vinylacetat, 2,66 g Dibenzoylperoxyd (75 gew.-%ig) werden in der in Beispiel 7 beschriebenen Apparatur 6,5 Stunden polymerisiert. Während des Verlaufs der Polymerisation werden dem Gemisch 807 g Methanol als Lösungsmittel zugesetzt.

Die Reaktion verläuft mit einem Umsatz von 69,2 Gew.-%, bezogen auf die eingesetzte Gesamtmonomerenmenge.

Die reduzierte spezifische Viskosität des erhaltenen Copolymerisats beträgt 90,5 ml/g, gemessen in Ethylacetat bei 25° C (c= 1,01 g/100 ml).

Beispiel 10

Herstellung eines Vinylestercopolymerisats

100 g Vinylacetat, 100 g Perfluorhexylethylen, 0,33 g Dibenzoylperoxid werden in der in Beispiel 7 beschriebenen Apparatur 8 Stunden bei 75° C unter Rückfluß polymerisiert. Nach Zugabe von 100 g Methanol wird weitere 6 Stunden polymerisiert. Nach Zugabe von 390 g Ethylacetat wird die Reaktionslösung am Rotationsverdampfer eingeengt bzw. destilliert. Der Umsatz beträgt 64,2 Gew.-%, bezogen auf die eingesetzte Gesamtmonomerenmenge. Das erhaltene Copolymerisat hat eine reduzierte spez. Viskosität von 20,4 ml/g (c= 1,0 g/100 ml), gemessen in Ethylacetat bei 25° C.

Beispiel 11

Herstellung eines Vinylestercopolymerisats

Eine Mischung aus 975,1 g Vinylacetat und 3,27 g Dibenzoylperoxid wird über eine Gasmaus, in der sich 4,9 g Hexafluorisobuten befinden, bei leichtem Vakuum in einen 3 l Autoklaven gesaugt.

Die anschließende Copolymerisation der Mischung wird bei 70 °C durchgeführt mit einer Polymerisationsdauer von 5 Stunden. Im Verlauf der Polymerisation wird der Ansatz mit 960 g Methanol verdünnt.

Man erhält ein copolymerisat mit 0,5 Gew.-% Hexafluorisobutenanteil, das eine reduzierte spezifische Viskosität von 89,2 ml/g besitzt, gemessen in Ethylacetat bei 25 °C mit einer Konzentration c von 1,01 g/100 ml.

Beispiel 12

Herstellung eines Vinylestercopolymerisats

16 g Allylhexafluorpropylether werden mit 784 g Vinylacetat und 2,66 g Dibenzoylperoxid vermischt und in der in Beispiel 7 beschriebenen Apparatur bei 40 °C 5,5 Stunden polymerisiert. Während der Polymerisation werden dem Ansatz 807 g Methanol zugesetzt.

Die Ausbeute beträgt 604,5 G Copolymerisat, welches eine reduzierte spez. Viskosität von 92,1 ml/g (c = 1,02 g/ 100 ml), gemessen in Ethylacetat bei. 25 °C, besitzt.

Beispiel 13

Herstellung eins Vinylestercopolymerisats und dessen Verseifung

Zur Polymerisation im Dosierverfahren wird in einer Reaktionsapparatur entsprechend Beispiel 1, aber mit Dosiereinrichtung, eine Mischung aus 3980 g Vinylacetat, 20 g Perfluoroctylethylen und 0,25 Gew.-%, bezogen auf Vinylacetat, Dibenzoylperoxid als Initiator hergestellt.

10 % dieser Mischung werden in der Reaktionsapparatur vorgelegt und auf 62 °C aufgeheizt. Bei Reaktionsbeginn wird mit der Zudosierung der restlichen 90 % der Mischung begonnen. Es wird 3 Stunden über eine Dosiereinheit dosiert. 25 Minuten vor Dosierende wird über eine weitere Dosiereinrichtung Methanol als Verdünnungsmittel der Reaktionsmischung zugeführt. Man erhält bei 3 Stunden und 40 Minuten Nachpolymerisation und einer Temperatur von 61 - 64 °C eine Polymerlösung mit einem Polymerisatgehalt von 31,9 Gew.-% entsprechend einem Restmonomergehalt von 8,1 Gew.-%.

Das restliche Vinylacetat wird unter weiteren Zusätzen von Methanol durch Vakuumdestillation entfernt. Das Copolymerisat weist eine reduzierte spezifische Viskosität von 139,1 ml/g bei c = 1,0 g/100 ml auf, gemessen in Ethylacetat bei 25 °C. Die Verseifung zum Terpolymerisat wird entsprechend Beispiel 2 durchgeführt.

Das erhaltene Terpolymerisat weist einen Hydrolysegrad von 86,3 Mol-% und eine Lösungsviskosität (Höppler) der 4 gew.-%igen wäßrigen Lösung von 754,0 mPa•s.

Das Produkt ist homogen und in Wasser klar löslich.

Beispiele 14 - 18

Herstellung von Vinylestercopolymerisaten

Entsprechend dem Vorgehen in Beispiel 1 werden Mischungen von je 4000 g, bestehend aus Vinylacetat und unterschiedlichen Mengen an comonomerem Perfluoroctylethylen, zur Copolymerisation gebracht. Es wird 7,5 Stunden unter Rückfluß polymerisiert.

Die Eigenschaften der erhaltenen Copolymerisate sind in Bezug auf die Viskosität in Abhängigkeit von

Comonomergehalt in Tabelle 1 aufgeführt.

Die Comonomeranteile im Polyvinylacetatcopolymerisat sind quantitativ über Fluoranalysen bestimmt worden.

Tabelle 1

Viskositätsverhalten der Vinylestercopolymerisate der Beispiele 14 - 18

| Beispiel Nr. | η sp/c 1) [ml/g] | Y 2) (Gew.-%) |
|---|---|---|
| 14 | 136,5 | 0,11 |
| 15 | 120,0 | 0,22 |
| 16 | 113,9 | 0,32 |
| 17 | 115,0 | 0,41 |
| 18 | 124,0 | 0,50 |

1) ηsp/c= Reduzierte spezifische Viskosität, angegeben in [ml/g] und gemessen in Ethylacetat bei 25°C an einer Lösung des Copolymerisats der Konzentration c = 1g/100 ml.

2) Y = Anteil (in Gew.-%) an comonomeren Perfluoroctylethyleneinheiten im Copolymerisat, bezogen auf das Copolymerisat.

Die Eigenschaften der nach der Methode des Beispiels 2 durch Verseifung der in den Beispielen 14 bis 18 erhaltenen Vinylestercopolymerisate hergestellten Terpolymerisate sind in Tabelle 2 aufgeführt.

Tabelle 2

Viskositätsverhalten der aus den Vinylestercopolymerisaten der Beispiele 14 - 18 durch Verseifung hergestellten Terpolymerisate

| Beispiel Nr. | HG[3] (Mol-%) | η[4] (mPa•s) | Z[5] (Gew.-%) |
|---|---|---|---|
| 14 | 86,4 | 22,8 | 0,18 |
| 15 | 86,6 | 41,5 | 0,37 |
| 16 | 86,5 | 86,8 | 0,53 |
| 17 | 87,1 | 228,0 | 0,72 |
| 18 | 87,0 | 449,3 | 0,94 |

3) HG = Hydrolysegrad (in Mol-%) der Vinylestereinheiten im Terpolymerisat

4) η = Viskosität der 4 gew.-%igen wäßrigen Lösung des Terpolymerisats, gemessen im Höppler-Viskosimeter bei 23°C.

5) Z = Anteil (in Gew.-%) an comonomeren Perfluoroctylethyleneinheiten im Terpolymerisat, bezogen auf das Terpolymerisat.

Vergleichsbeispiel A

Herstellung von Polyvinylacetat

In einer Polymerisationsappparatur entsprechend Beispiel 7 werden 1000 g Vinylacetat innerhalb von 8 Stunden bei 60 - 75° C homopolymerisiert. 0,25 Gew.-%, bezogen auf Vinylacetat, 75 gew.-%iges Dibenzoylperoxid werden als Initiator verwendet. Im Verlauf der Polymerisationsdauer wird die Polymerisationslösung stufenweise mit Methanol auf 50 Gew.-% Methanolgehalt verdünnt, die Polymerisationsreaktion durch Zugabe von Hydrochinon abgestoppt und das Gemisch mit weiterem Methanol auf 40 Gew.-% Methanolgehalt verdünnt. Die erhaltene Polymerisatlösung weist einen Restmonomergehalt von 4,47 Gew.-% auf.

Die reduzierte spezifische Viskosität des resultierenden Polyvinylacetats beträgt 125,8 ml/g bei einer Konzentration c von 1,0 g/100 ml und einer Temperatur von 25° C (Ostwald-Viskosimeter), gemessen in Ethylacetat.

Vergleichsbeispiel B

Herstellung von Polyvinylalkohol durch Verseifung von homopolymerem Polyvinylacetat

800 g des im Vergleichsbeispiel A hergestellten Polyvinylacetathomopolymerisats werden in 2400 g Methanol gelöst. Mit dieser Lösung wird sodann analog wie in Beispiel 8 beschrieben verfahren. Die Verseifungstemperatur beträgt 22° C.

Nach 90 Minuten wird das granulierte Verseifungsprodukt zum Abstoppen der Verseifungsreaktion in eine

Mischung aus 8,4 ml konzentrierter Essigsäure und 800 g Methanol gegeben. Anschließend wird bei 70° C im Vakuumschrank getrocknet. Man erhält ein Polyvinylalkohol-Homopolymerisat mit einem Hydrolysegrad von 85,7 Mol-% und einer Höppler-Viskosität von 14,9 mPa•s.

Die 4 gew.-%ige wäßrige Lösung ist homogen und weist keinerlei Trübung auf.

Das erhaltene Vergleichsprodukt zeigt gegenüber den erfindungsgemäßen Produkten der Beispiele 14 - 18 eine deutlich niedrigere Viskosität.

Vergleichsbeispiel C

Herstellung eines Tetrafluorethyleneinheiten (TFE) enthaltenden Polyvinylalkohols

400 g eines Tetrafluorethylen-Vinylacetat-Copolymerisats mit einem TFE-Gehalt von 2,7 Gew.-% werden in 2267 g Methanol gelöst. Das Copolymerisat hat in Ethylacetat bei 25° C und einer Konzentration c von 1,02 g/100 ml eine reduzierte spezifische Viskosität von 359,4 ml/g.

In die 15 gew.-%ige methanolische Polymerisatlösung werden unter starkem Rühren 28 g Wasser und 32 g 10 gew.-%ige methanolische Natronlauge gegeben. Nach 94 Minuten wird das granuliert vorliegende, alkalische Produkt in einer Mischung aus 400 g Methanol und 4,8 ml konzentrierter Essigsäure neutralisiert.

Der resultierende modifizierte Polyvinylalkohol enthält 4,1 Gew.-% Tetrafluorethylen einpolymerisiert. Der Hydrolysegrad beträgt 85,9 Mol-%. Die Höppler-Viskosität der 4 gew.-%igen wäßrigen Lösung beträgt 40,4 mPa•s, gemessen bei 23° C.

Die wäßrige Lösung ist trüb und weist nach längerem Stehen einen Bodensatz auf.

Vergleichsbeispiel D

Zur Erzielung eines höheren Hydrolysegrades wird das Produkt aus Vergleichsbeispiel C mit 1,5 Gew.-% 10 gew.-%iger methanolischer Natronlauge bei Raumtemperatur behandelt. Nach 3 Stunden wird die Methanolysereaktion mit äquimolaren Mengen an konzentrierter Essigsäure in 400 g Methanol abgestoppt.

Der resultierende TFE-haltige, terpolymere Polyvinylalkohol mit einem Gehalt von 4,5 Gew.-% Tetrafluorethyleneinheiten hat einen Hydrolysegrad von 97,4 Mol-%.

Die Höppler-Viskosität der 4 gew.-%igen wäßrigen Lösung beträgt 68,2 mPa•s, gemessen bei 23° C.

Die wäßrige Lösung ist homogen und klar und weist auch nach längerem Stehen keine Phasentrennung auf.

Vergleicht man die entsprechenden Viskositäten wäßriger Polyvinylalkohollösungen auf Beispiel 18 und Vergleichsbeispiel B miteinander, so wird der erfindungsgemäße Unterschied deutlich. Bei annähernd gleichen reduzierten spezifischen Viskositäten der Ausgangspolyvinylacetat-Lösungen in Ethylacetat, Beispiel 18 mit 124 ml/g und Vergleichsbeispiel A mit 125,8 ml/g, unterscheidet sich die Viskosität der wäßrigen Lösung des erfindungsgemäßen Polyvinylalkohols aus Beispiel 18 um den beachtlichen Faktor von 30,2 von der Viskosität der wäßrigen Lösung des Vergleichsproduktes aus Vergleichsbeispiel B bei gleicher Konzentration.

Das durch Tetrafluorethyleneinheiten modifizierte Polyvinylacetat (Vergleichsbeispiel C) weist in dem Lösungsmittel Ethylacetat, im Gegensatz zu den erfindungsgemäß modifizierten Polyvinylacetaten der Beispiele 14 - 18, eine hohe reduzierte spezifische Viskosität auf, die zu erheblichen Löseproblemen, z.B. in Methanol, führt bzw. die Herstellung von höher konzentrierten methanolischen Lösungen beträchtlich erschwert oder gar unmöglich machen kann. Die erfindungsgemäß modifizierten Polyvinylacetate der Beispiele 14 - 18 weisen diesen Nachteil jedoch überraschenderweise nicht auf.

Andererseits aber zeigen die wäßrigen Lösungen der aus Produkten das Vergleichsbeispiels C im Vergleichsbeispiel D durch Hydrolyse erhaltenen terpolymeren Polyvinylalkohole niedrige Lösungsviskositäten, trotz der hohen Viskosität der methanolischen Lösungen ihrer zugrundeliegenden modifizierten Ausgangspolyvinylacetate aus Vergleichsbeispiel C. In diesem Eigenschaftsbild unterscheiden sich die erfindungsgemäßen Produkte grundlegend und deutlich vom Stand der Technik.

Beispiel 19

Herstellung eines Crotonsäure und Perfluorhexylethylen enthaltenden Vinylesterterpolymerisats

76,4 g einer Mischung aus 760 g Vinylacetat und 4 g t-Butyl-per-2-ethylhexanoat als Initiator (Mischung I) werden in einer Reaktionsapparatur entsprechend Beispiel 7, die zusätzlich mit einer Dosiereinrichtung ausgestattet ist, vorgelegt.

Als Dosierlösung aus einen 1 l-Dosiertrichter wird eine Mischung (Mischung II) hergestellt, bestehend aus 687,6 g der Mischung I, 32,0 g Crotonsäure und 8,0 g Perfluorhexylethylen.

Die vorgelegte Mischung I wird auf 73 °C aufgeheizt. Mit Erreichen dieser Temperatur wird mit der Zudosierung der Mischung II begonnen. Mischung II wird 3 Stunden zudosiert. Während dieser Zeit wird die Polymerisationstemperatur zwischen 73 - 74 °C gehalten. Die Badtemperatur wird während der gesamten Polymerisationsdauer konstant bei 80 °C gehalten. Überschreitet die Innentemperatur 75 °C etwa 45 - 60 Minuten nach Dosierende der Mischung II, wird die Reaktionslösung in Stufen mit 89 g, 111 g, 143 g sowie 190 g Methanol verdünnt. Die Reaktionstemperatur sinkt nach der ersten Methanolzugabe auf 60 °C ab und steigt im weiteren Verlauf der Polymerisation auf 65 °C an.

Eine Stunde sowie drei Stunden nach Dosierende der Mischung II werden der Reaktionslösung jeweils 1,6 g Bis(4-t-butylcyclohexyl-)peroxydicarbonat als Initiator zugesetzt.

5 1/4 Stunden nach Dosierende der Mischung II wird die Polymerisationslösung mit weiteren 667 g Methanol verdünnt, die Polymerisationsreaktion durch Zusatz von 50 mg Hydrochinon abgestoppt und das Gemisch auf Raumtemperatur abgekühlt. Die resultierende 40 gew.-%ige methanolische Lösung weist einen Restmonomergehalt von 1,69 Gew.-% auf.

Nach Trocknung bei 70 °C unter Vakuum erhält man 768 g Vinylacetatterpolymerisat. Der Crotonsäuregehalt wird nach üblichen Methoden titrimetrisch bestimmt.

Die reduzierte spezfische Viskosität des Produktes bei 25 °C in Ethylacetat ergibt sich zu 81,3 ml/g, bei einer Konzentration c der Ethylacetat-Lösung von 1,05 g/100 ml.

Beispiel 20

Verseifung des im Beispiel 19 beschriebenen terpolymeren Polyvinylacetats zum quaterpolymeren Polyvinylalkohol

700 g nach Beispiel 19 hergestelltes und 0,34 Mol-% Crotonsäure enthaltendes Polyvinylacetat-Terpolymerisat werden in 1633 g Methanol gelöst. Zur Neutralisation der Carboxylgruppen werden äquimolare Mengen an 10 gew.-%iger methanolischer Natronlauge hinzugefügt sowie 280 g 10 gew.-%ige methanolische NaOH-Lösung als Verseifungskatalysator zugesetzt.

Die Mischung wird ca. 2 Minuten unter Rühren homogenisiert. Das entstehende feste, alkalische Gel wird vermahlen und nach 45 Minuten mit 62,4 g Essigsäure unter Beigabe von 700 g Methanol 1 Stunde neutralisiert. Das neutralisierte Produkt wird mit Methanol gewaschen, anschließend wird über eine Nutsche abgesaugt und das Festprodukt im Trockenschrank getrocknet. Man erhält 341 g quaterpolymeren Polyvinylalkohol mit einem Feststoffgehalt von 97 Gew.-%.

Der Hydrolysegrad beträgt 95 Mol-%.

Die Viskosität der 4 gew.-%igen wäßrigen Lösung, gemessen bei 23 °C im Höppler-Viskosimeter, ergibt sich zu 21,1 mPa•s. Die 10 gew.-%ige wäßrige Lösung besitzt eine Viskosität von 85,5 mPa•s,gemessen bei 85 °C im Rheomat 30 der Fa. Contraves. Das Produkt weist eine hervorragende Alkalilöslichkeit auf.

Beispiel 21

76,7 g einer Mischung aus 761,6 g Vinylacetat und 5,33 g Dibenzoylperoxid (Mischung I) werden in einer Apparatur entsprechend Beispiel 19 vorgelegt.

690,2g der Mischung I werden mit 32 g Crotonsäure und 6,4 g Perfluoroctylethylen versetzt (Mischung II).

Die vorgelegte Mischung I wird auf 74 °C aufgeheizt, und nach Erreichen dieser Temperatur wird mit der 3-stündigen Dosierung von Mischung II begonnen. Im weiteren wird entsprechend Beispiel 19 vorgegangen.

Am Ende der Polymerisationslaufzeit erhält man eine methanolische Polyvinylacetat-Terpolymerisat-Lösung (40 gew.-%ig) mit einem Restmonomergehalt von 1,48 Gew.-%.

Nach Trocknung ergeben sich 757 g Terpolymerisat. Die 1 gew.-%ige Lösung in Ethylacetat besitzt eine reduzierte spezifische Viskosität $\eta$ sp/c von 59,4 ml/g.

Der Gehalt an Crotonsäureeinheiten in dem Terpolymerisat läßt sich tritrimetrisch zu 4,5 Gew.-% bestimmen.

Beispiel 22

Die Verseifung des nach Beispiel 21 hergestellten Polyvinylacetat-Terpolymerisats zum Polyvinylalkohol-Quaterpolymerisat wird entsprechend dem Beispiel 20 durchgeführt. Der erfindungsgemäß modifizierte Polyvinylalkohol weist einen Hydrolysegrad von 94,9 Mol-% auf und seine 4 gew.-%ige wäßrige Lösung besitzt eine Viskosität von 23,4 mPa•s bei 23° C (Höppler).

Die 10 gew.-%ige wäßrige Polyvinylalkohol-Quaterpolymerisatlösung hat eine Viskosität von 134,7 mPa•s, gemessen bei 85° C mit dem Rheomat 30.

Vergleichsbeispiel E

Herstellung von carboxylgruppenhaltigem copolymerem Polyvinylacetat

390 g einer Mischung aus 3880 g Vinylacetat und 20 g t-Butyl-per-2-ethylhexanoat als Initiator werden in einer Reaktionsapparatur entsprechend Beispiel 13 vorgelegt. Die verbleibenden 90 % der Mischung werden mit 120 g Crotonsäure vermischt und 3 Stunden der Vorlagemischung zudosiert. Im weiteren wird der Versuch analog wie in Beispiel 3 beschrieben durchgeführt.

Die 40 gew.-%ige methanolische Reaktionslösung weist einen titrimetrisch bestimmten Restmonomergehalt von 0,3 . Gew.-% auf.

Die reduzierte spezifische Viskosität $\eta$ sp/c des Copolymerisats, gemessen in Ethylacetat bei 25° C und einer Konzentration c von 1,0 g/100 ml, beträgt 86,7 ml/g.

Der Crotonsäuregehalt des Copolymerisats wird titrimetrisch zu 3,2 Gew.-% ermittelt.

Vergleichsbeispiel F

Verseifung des im Vergleichsbeispiel E beschriebenen crotonsäurehaltigen copolymeren Polyvinylacetats

2522 g einer 39,65 gew.-%igen methanolischen Lösung des in Vergleichsbeispiel E synthetisierten Copolymerisats werden mit 811 g Methanol verdünnt. Zur Neutralisation des 3,2 Gew.-% betragenden Crotonsäureanteils im Copolymerisat werden der Polymerlösung außer 300 g 10 gew.-%iger methanolischer Natronlauge zur Verseifung zusätzlich noch weitere 150 g 10 gew.-%ige methanolische Natronlauge zugesetzt. Das während der alkalischen Umesterung entstehende feste Gel wird gemahlen und nach 45 Minuten mit 67,5 g konzentrierter Essigsäure unter Hinzufügung von 1000 g Methanol innerhalb von einer Stunde neutralisiert. Das neutralisierte Produkt wird mit weiterem Methanol gewaschen und über einer Nutsche abgesaugt und anschließend bei 70° C im Trockenschrank unter Vakuum getrocknet. Das erhaltene crotonsäurehaltige Terpolymerisat hat einen Hydrolysegrad von 95,3 Mol-%. Die im Höppler-Viskosimeter gemessene Viskosität der 4 gew.-%igen wäßrigen Lösung des Terpolymerisats von 23° C beträgt 9,8 mPa•s bei einem pH-Wert von 7,0. Die 10 gew.-%ige wäßrige Lösung des Terpolymerisats hat bei 85° C eine Viskosität von 20,8 mPa•s. Das Produkt ist gut alkalilöslich.

Trotz einer deutlich niedrigeren reduzierten spezifischen Viskosität des modifizierten erfindungsgemäßen Polyvinylacetats in Ethylacetat (25° C) von 59,4 ml/g bei einer Konzentration von 1 g/100 ml (Beispiel 21), vergleichsweise zu 86,7 ml/g des in dem Vergleichsbeispiel E beschriebenen Produktes, weist der erfindungsgemäß modifizierte Polyvinylalkohol aus Beispiel 22 eine wesentlich höhere Viskosität der wäßrigen Lösung von 23,4 mPa•s bei 23° C und einer Konzentration von 4 Gew.-%, gegenüber 9,8 mPa•s unter gleichen Bedingungen bei dem Vergleichsprodukt aus Vergleichsbeispiel F, auf.

Noch wesentlich deutlicher tritt der Unterschied bei den erzeugten Viskositäten der 10 gew.-%igen wäßrigen Lösungen, gemessen bei 85° C, hervor.

Der für ein Fasergarn-Schlichtematerial geforderte und notwendige Bereich der Viskositäten von 60 -

120 mPa•s. (10 gew.-%ig, 85° C) in Wasser wird von dem Vergleichsprodukt aus Vergleichsbeispiel F nicht erreicht. Letzteres ist somit für den Einsatz als Fasergarnschlichtemittel nicht geeignet.

Überraschend ist weiterhin, daß trotz eines höheren Crotonsäuregehaltes im Produkt des Beispiels 22, im Vergleich zu dem Produkt aus Vergleichsbeispiel F, die Viskosität des erfindungsgemäßen Hydrolyseproduktes aus Beispiel 22 in Wasser deutlich höher ist, obwohl ein höherer Crotonsäureanteil während der Polymerisation unter nicht erfindungsgemäßen Bedingungen die Viskosität der entsprechenden Polyvinylalkohole in Wasser erwartungsgemäß hätte herabsetzen müssen.

## Ansprüche

**1.** Fluorhaltige Copolymerisate, hergestellt durch radikalisch initiierte Copolymerisation von ethylenisch ungesättigten copolymerisationsfähigen Monomeren, enthaltend als Monomereinheiten Vinylester, fluorhaltige ethylenisch ungesättigte Monomere, gegebenenfalls ethylenisch ungesättigte Mono- und/oder Dicarbonsäuren und gegebenenfalls weitere Monomere, wobei gegebenenfalls die Vinylestereinheiten teilweise oder vollständig zu Vinylalkoholeinheiten verseift sind, dadurch gekennzeichnet, daß sie fluorhaltige Monomereinheiten der Formel I,

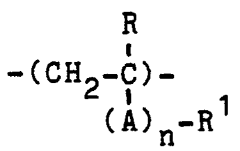

(I)

worin

R = H, $-CH_3$, $-CF_3$,

A = $-CH_2-$, -O-, $CH_2-O-(CH_2)_m-$,

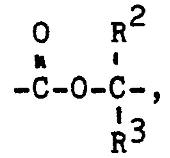

wobei $R^2$ und $R^3$, die gleich oder verschieden sein können, für H,($C_1$-$C_4$)-Alkyl, $-CF_3$ oder $R^1$ stehen,

n = 0 - 1, m = 0 - 2,

$R^1$ = $C_pF_{2p+1}$, $-C_pF_{2p}X$, $-C_pF_{2p-1}XH$, die linear oder verzweigt sein können,

p = 2 - 20, und X = Halogen

bedeutet, enthalten.

**2.** Fluorhaltige Copolymerisate nach Anspruch 1, dadurch gekennzeichnet, daß sie 0,05 bis 60 Gew.-%, bezogen auf das Copolymerisat fluorhaltige Monomereinheiten der Formel I enthalten.

**3.** Fluorhaltige Copolymerisate nach Ansprüchen 1 und 2, dadurch gekennzeichnet, daß der Vinylester Vinylacetat ist.

**4.** Fluorhaltige Copolymerisate nach Ansprüchen 1 bis 3, dadurch gekennzeichnet, daß sie Mono- und/oder Dicarbonsäureeinheiten der Formel II,

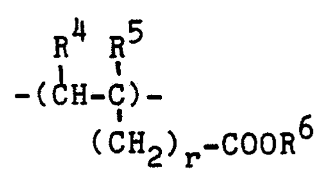

(II)

worin

$R^4$ = H, -COOH, $(C_1\text{-}C_5)$-Alkyl,
$R^5$ = H, $-CH_3$, -COOH,
wobei $R^4$ und $R^5$ gleich oder verschieden sein können,
r = 0 - 5,
$R^6$ = H, $NH_4$, Na, K, Li
bedeutet, enthalten.

5. Fluorhaltige Copolymerisate nach Ansprüchen 1 bis 4, dadurch gekennzeichnet, daß der Verseifungsgrad der Vinylestereinheiten 40 bis 100 Mol-% beträgt.

6. Verfahren zur Herstellung fluorhaltiger Copolymerisate nach Ansprüchen 1 bis 5 durch radikalisch initiierte Copolymerisation von copolymerisationsfähigen Vinylestern mit fluorhaltigen ethylenisch ungesättigten Monomeren, gegebenenfalls ethylenisch ungesättigten Mono- und/oder Dicarbonsäuren und gegegebenenfalls weiteren Monomeren sowie gegebenenfalls nachfolgender teilweiser oder vollständiger Verseifung der Vinylestereinheiten zu Vinylalkoholeinheiten, dadurch gekennzeichnet, daß zur Copolymerisation fluorhaltige Monomere, der Formel Ia,

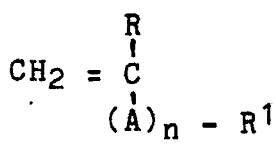 (Ia)

worin R, $R^1$, A und n die Bedeutung wie in Formel I haben, eingesetzt werden.

7. Verfahren nach Anspruch 6, dadurch gekennzeichnet, daß zur Copolymerisation 0,05 bis 60 Gew.-%, bezogen auf die eingesetzte Gesamtmonomerenmenge, fluorhaltige Monomere der Formel Ia eingesetzt werden.

8. Verfahren nach Ansprüchen 6 und 7, dadurch gekennzeichnet, daß die Copolymerisation in der Masse und/oder in Lösung durchgeführt wird.

9. Verwendung der fluorhaltigen Copolymerisate nach Ansprüchen 1 bis 5 zur Herstellung von Folien.

10. Verwendung der teilweise oder vollständig verseiften fluorhaltigen Copolymerisate nach Ansprüchen 1 bis 5 als Emulgatoren, Schutzkolloide, Klebstoffkomponenten, zur Oberflächenmodifizierung von organischen und/oder anorganischen Substraten, als Bestandteil in photosensitiven Schichten und/oder in photosensitiven Druckplatten, zur Herstellung von wäßrigen Hydraulikflüssigkeiten sowie als Hilfsmittel bei der tertiären Erdölförderung.

11. Verwendung der teilweise oder vollständig verseiften und Carboxylgruppen enthaltenden fluorhaltigen Copolymerisate nach Ansprüchen 1 bis 5 als Papierbeschichtungsmittel sowie als Schlichtemittel.

Patentansprüche für folgenden Vertragsstaat: AT

1. Verfahren zur Herstellung fluorhaltiger Copolymerisate durch radikalisch initiierte Copolymerisation von ethylenisch ungesättigten copolymeriationsfähigen Monomeren, enthaltend als Monomere Vinylester, fluorhaltige ethylenisch ungesättigte Monomere, gegebenenfalls ethylenisch ungesättigte Mono- und/oder Dicarbonsäuren und gegegebenenfalls weitere Monomere sowie gegebenenfalls nachfolgende teilweise oder vollständige Verseifung der Vinylestereinheiten zu Vinylalkoholeinheiten, dadurch gekennzeichnet, daß zur Copolymerisation fluorhaltige Monomere, der Formel Ia,

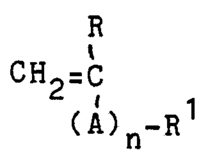 (Ia)

worin

R = H, $-CH_3$, $-CF_3$,

A = $-CH_2-$, -O-, $CH_2-O-(CH_2)_m-$,

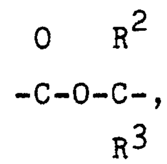

wobei $R^2$ und $R^3$, die gleich oder verschieden sein können, für H, $(C_1-C_4)$-Alkyl, $-CF_3$ oder $R^1$ stehen,

n = 0 - 1 , m = 0 - 2,

$R^1$ = $-C_pF_{2p+1}$, $-C_pF_{2p}X$, $-C_pF_{2p-1}XH$, die linear oder verzweigt sein können,

p = 2 - 20, und X = Halogen

bedeutet, eingesetzt werden.

2. Verfahren nach Anspruch 1, dadurch gekennzeichnet, daß zur Copolymerisation 0,05 bis 60 Gew.-%, bezogen auf die eingesetzte Gesamtmonomerenmenge, fluorhaltige Monomere der Formel Ia eingesetzt werden.

3. Verfahren nach Anspruch 1 und 2, dadurch gekennzeichnet, daß als Vinylester Vinylacetat eingesetzt wird.

4. Verfahren nach Ansprüchen 1 bis 3, dadurch gekennzeichnet, daß als ethylenisch ungesättigte Mono- und/oder Dicarbonsäuren Verbindungen der Formel IIa,

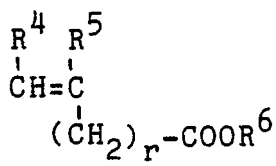
(IIa)

worin

$R^4$ = H, -COOH, $(C_1-C_5)$-Alkyl,

$R^5$ = H, $-CH_3$, -COOH,

wobei $R^4$ und $R^5$ gleich oder verschieden sein können,

r = 0 - 5,

$R^6$ = H, $NH_4$, Na, K, Li

bedeutet, eingesetzt werden.

5. Verfahren nach Ansprüchen 1 bis 4, dadurch gekennzeichnet, daß 40 bis 100 Mol-% der Vinylestereinheiten zu Vinylalkoholeinheiten verseift werden.

6. Verfahren nach Ansprüchen 1 bis 5, dadurch gekennzeichnet, daß die Copolymerisation in der Masse und/oder in Lösung durchgeführt wird.

7. Verwendung der fluorhaltigen Copolymerisate, hergestellt nach Ansprüchen 1 bis 6, zur Herstellung von Folien.

8. Verwendung der teilweise oder vollständig verseiften fluorhaltigen Copolymerisate, hergestellt nach Ansprüchen 1 bis 6, als Emulgatoren, Schutzkolloide, Klebstoffkomponenten, zur Oberflächenmodifizierung von organischen und/oder anorganischen Substraten, als Bestandteil in photosensitiven Schichten und/oder in photosensitiven Druckplatten, zur Herstellung von wäßrigen Hydraulikflüssigkeiten sowie als Hilfsmittel bei der tertiären Erdölförderung.

**9.** Verwendung der teilweise oder vollständig verseiften und Carboxylgruppen enthaltenden fluorhaltigen Copolymerisate, hergestellt nach Ansprüchen 1 bis 6, als Papierbeschichtungsmittel sowie als Schlichtemittel.

## Claims

**1.** Fluorine-containing copolymers prepared by free radical-initiated copolymerization of ethylenically unsaturated, copolymerizable monomers containing, as monomer units, vinyl esters, fluorine-containing, ethylenically unsaturated monomers, if appropriate ethylenically unsaturated monocarboxylic and/or dicarboxylic acids and, if appropriate, further monomers, the vinyl ester units being, if appropriate, partly or completely saponified to give vinyl alcohol units, characterized in that they contain fluorine-containing monomer units of the formula I

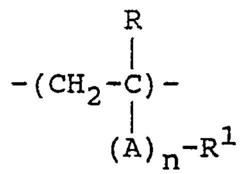

(I)

in which
R denotes H, $-CH_3$ or $-CF_3$,
A denotes $-CH_2-$, -O-, $CH_2-O-(CH_2)_m-$ or

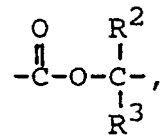

with $R^2$ and $R^3$, which can be identical or different, representing H, $(C_1-C_4)$-alkyl, $-CF_3$ or $R^1$,
n denoting 0 or 1 and m denoting 0 to 2,
$R^1$ denotes $-C_pF_{2p+1}$, $-C_pF_{2p}X$, $-C_pF_{2p-1}XH$, which can be linear or branched, p denoting 2 to 20, and X denoting halogen.

**2.** Fluorine-containing copolymers as claimed in claim 1, characterized in that they contain 0.05 to 60 % by weight, relative to the copolymer, of fluorine-conatining monomer units of the formula I.

**3.** Fluorine-containing copolymers as claimed in claims 1 and 2, wherein the vinyl ester is vinyl acetate.

**4.** Fluorine-containing copolymers as claimed in any of claims 1 to 3, characterized in that they contain monocarboxylic and/or dicarboxylic acid units of the formula II

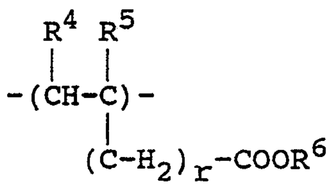

(II)

in which
$R^4$ denotes H, -COOH or $(C_1-C_5)$-alkyl,
$R^5$ denotes H, $-CH_3$ or -COOH, it being possible for $R^4$ and $R^5$ to be identical or different,
r denotes 0 to 5 and
$R^6$ denotes H, $NH_4$, Na, K or Li.

**5.** Fluorine-containing copolymers as claimed in any of claims 1 to 4, characterized in that the degree of saponification of the vinyl ester units is 40 to 100 mole %.

**6.** A process for the preparation of fluorine-containing copolymers as claimed in any of claims 1 to 5 by free radical-initiated copolymerization of copolymerizable vinyl esters with fluor-containing, ethylenically unsaturated monomers, if appropriate ethylenically unsaturated monocarboxylic and/or dicarboxylic acids and, if appropriate, further monomers, and, if appropriate, by subsequent partial or complete saponification of the vinyl ester units to give vinyl alcohol units, characterized in that fluorine-containing monomers of the formula Ia

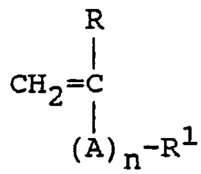

(Ia)

are employed for the copolymerization, where R, $R^1$, A and n have the same meaning as in formula I.

**7.** The process as claimed in claim 6, characterized in that 0.05 to 60 % by weight, relative to the total amount of monomers used, of fluorine-containing monomers of the formula Ia are employed for the copolymerization.

**8.** The process as claimed in claims 6 and 7, characterized in that the copolymerization is carried out in the mass and/or in solution.

**9.** Use of the fluorine-containing copolymers as claimed in claims 1 to 5 for the production of films.

**10.** Use of the partially or completely saponified fluorine-containing copolymers as claimed in any of claims 1 to 5 as emulsifiers, protective colloids or components of adhesives, for modifying the surfaces of organic and/or inorganic substrates, as constituents in photosensitive layers and/or in photosensitive printing plates, for the preparation of aqueous hydraulic fluids and as auxiliaries in tertiary petroleum extraction.

**11.** Use of the partially or completely saponified, fluorine-containing copolymers which contain carboxyl groups as claimed in any of claims 1 to 5 as paper coating agents and as sizing agents.

Claims for the following Contracting State: AT

**1.** Process for preparing fluorine-containing copolymers by free radical-initiated copolymerization of ethylenically unsaturated, copolymerizable monomers containing, as monomers, vinyl esters, fluorine-containing, ethylenically unsaturated monomers, if appropriate ethylenically unsaturated monocarboxylic and/or dicarboxylic acids and, if appropriate, further monomers, the vinyl ester units subsequently being, if appropriate, partly or completely saponified to give vinyl alcohol units, characterized in that fluorine-containing monomer units of the formula Ia

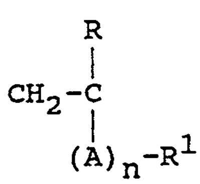

(Ia)

in which

R denotes H, $-CH_3$ or $-CF_3$,

A denotes $-CH_2-$, $-O-$, $CH_2-O-(CH_2)_m-$ or

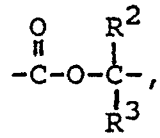

with $R^2$ and $R^3$, which can be identical or different, representing H, $(C_1-C_4)$-alkyl, $-CF_3$ or $R^1$,

n denoting 0 or 1 and m denoting 0 to 2,

$R^1$ denotes $-C_pF_{2p+1}$, $-C_pF_{2p}X$, $-C_pF_{2p-1}XH$, which can be linear or branched, p denoting 2 to 20, and X denoting halogen,

are used for the copolymerization.

2. The process as claimed in claim 1, characterized in that 0.05 to 60 % by weight, relative to the amount of copolymer employed, of fluorine-containing monomer units of the formula I, are used.

3. The process as claimed in claims 1 and 2, wherein the vinyl ester is vinyl acetate.

4. The process as claimed in any of claims 1 to 3, characterized in that compounds of the formula IIa

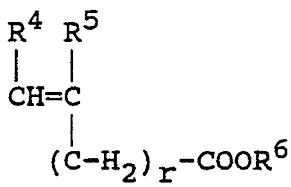

(IIa)

in which

$R^4$ denotes H, -COOH or $(C_1-C_5)$-alkyl,

$R^5$ denotes H, $-CH_3$ or -COOH, it being possible for $R^4$ and $R^5$ to be identical or different,

r denotes 0 to 5 and

$R^6$ denotes H, $NH_4$, Na, K or Li,

are employed as ethylenically unsaturated monocarboxylic and/or dicarboxylic acids.

5. The process as claimed in any of claims 1 to 4, characterized in that 40 to 100 mole % of the vinyl ester units are saponified to give vinyl alcohol units.

6. The process as claimed in claims 1 to 5, characterized in that the copolymerization is carried out in the mass and/or in solution.

7. Use of the fluorine-containing copolymers prepared as claimed in claims 1 to 6, for the production of films.

8. Use of the partially or completely saponified fluorine-containing copolymers prepared as claimed in any of claims 1 to 6, as emulsifiers, protective colloids or components of adhesives, for modifying the surfaces of organic and/or inorganic substrates, as constituents in photosensitive layers and/or in photosensitive printing plates, for the preparation of aqueous hydraulic fluids and as auxiliaries in tertiary petroleum extraction.

9. Use of the partially or completely saponified, fluorine-containing copolymers which contain carboxyl groups and have been prepared as claimed in any of claims 1 to 6, as paper coating agents and as sizing agents.

**Revendications**

**1.** Copolymères contenant du fluor, préparés par une copolymérisation, à amorçage radicalaire, de monomères à insaturation éthylénique, capables d'une copolymérisation, ces copolymères contenant comme motifs monomères des esters vinyliques, des monomères fluorés à insaturation éthylénique, éventuellement des acides mono- et/ou di-carboxyliques à insaturation éthylénique et éventuellement d'autres monomères, les motifs esters vinyliques étant éventuellement saponifiés, partiellement ou totalement, en des motifs alcools vinyliques, copolymères caractérisés en ce qu'ils contiennent des motifs monomères fluorés de formule I :

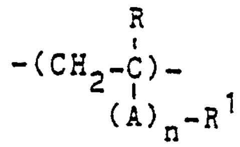

(I)

dans laquelle :

R représente H, $-CH_3$, $-CF_3$,

A représente $-CH_2-$, $-O-$, $-CH_2-O-(CH_2)_m-$,

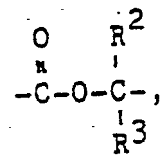

(où $R^2$ et $R^3$, qui peuvent être identiques ou différents, représentent chacun H, un groupe alkyle en $C_1$ à $C_4$, un groupe $-CF_3$ ou $R^1$),
n vaut 0 à 1, m vaut 0 à 2,

$R^1$ représente un groupe $-C_pF_{2p+1}$, $-C_pF_{2p}X$, $-C_pF_{2p-1}XH$, qui peuvent être linéaires ou ramifiés, p vaut 2 à 20 et X représente un atome d'halogène.

**2.** Copolymères fluorés selon la revendication 1, caractérisés en ce qu'ils contiennent 0,05 à 60 % en poids, sur la base du copolymère, de motifs monomères fluorés de formule I.

**3.** Copolymères fluorés selon les revendications 1 et 2, caractérisés en ce que l'ester vinylique est l'acétate de vinyle.

**4.** Copolymères fluorés selon les revendications 1 à 3, caractérisés en ce qu'ils contiennent des motifs mono- et/ou di-carboxyliques de formule II :

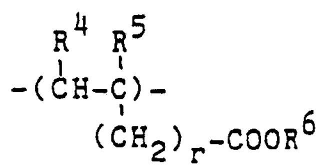

(II)

dans laquelle :

$R^4$ et $R^5$ peuvent être identiques ou différents et ils représentent chacun :

$R^4$ un atome d'hydrogène, un groupe -COOH, un groupe alkyle en $C_1$ à $C_5$,

$R^5$ un atome d'hydrogène, un groupe $-CH_3$, ou -COOH,

r vaut 0 à 5,

$R^6$ représente un atome d'hydrogène, un groupe $NH_4$, un atome de Na; K, Li.

**5.** Copolymères fluorés selon les revendications 1 à 4, caractérisés en ce que le degré de saponification des motifs esters vinyliques est de 40 à 100 moles %.

**6.** Procédé pour préparer des copolymères fluorés selon les revendications 1 à 5, par une copolymérisation, à amorçage radicalaire, d'esters vinyliques pouvant être copolymérisés avec des monomères fluorés à insaturation éthylénique, éventuellement des acides mono- et/ou di-carboxyliques à insaturation éthylénique et éventuellement d'autres monomères, avec éventuellement une saponification subséquente, partielle ou totale, des motifs esters vinyliques en des motifs alcools vinyliques, procédé caractérisé en ce qu'on utilise pour la copolymérisation des monomères fluorés de formule Ia :

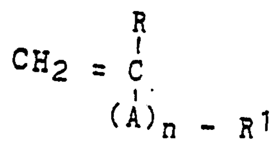

(Ia)

dans laquelle R, $R^1$, A et n ont le sens indiqué pour la formule I.

7. Procédé selon la revendication 6, caractérisé en ce qu'on utilise pour la copolymérisation 0,05 à 60 % en poids, sur la base de la quantité totale des monomères que l'on utilise, de monomères fluorés de formule Ia.

8. Procédé selon les revendications 6 et 7, caractérisé en ce qu'on conduit la polymérisation en masse et/ou en solution.

9. Utilisation des copolymères fluorés selon les revendications 1 à 5 pour la production de feuilles.

10. Utilisation des copolymères fluorés, partiellement ou entièrement saponifiés, selon les revendications 1 à 5 à titre d'émulsifiants, de colloïdes protecteurs, de composants de colle, pour modifier la surface de substrats organiques et/ou minéraux, comme constituants dans des couches photosensibles et/ou dans des plaques d'impression photosensibles, pour préparer des fluides hydrauliques aqueux ainsi que comme adjuvants dans la récupération tertiaire d'une huile de pétrole minérale.

11. Utilisation des copolymères fluorés, partiellement ou entièrement saponifiés et contenant des groupes carboxyles, selon les revendications 1 à 5, comme produits de revêtement de papier ainsi que comme produits d'encollage.

Revendications pour l'Etat contractant suivant : AT

1. Procédé pour préparer des copolymères fluorés, par une copolymérisation, à amorçage radicalaire, de monomères copolymérisables à insaturation éthylénique, contenant comme monomères des esters vinyliques, des monomères fluorés à insaturation éthylénique, éventuellement des acides mono- et/ou di-carboxyliques à insaturation éthylénique et éventuellement d'autres monomères, avec éventuellement une saponification subséquente, partielle ou totale, des motifs esters vinyliques en des motifs alcools vinyliques, procédé caractérisé en ce qu'on utilise pour la copolymérisation des monomères fluorés de formule Ia :

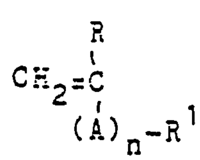

(Ia)

dans laquelle :

R représente H, un groupe $-CH_3$ ou $-CF_3$,

A représente un groupe $-CH_2-$, $-O-$, $-CH_2-O-(CH_2)_m-$,

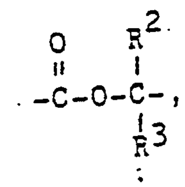

formules dans lesquelles les symboles $R^2$ et $R^3$ , qui peuvent être identiques ou différents, représentent chacun H, un groupe alkyle en $C_1$ à $C_4$, $-CF_3$ ou $R^1$,
n vaut 0 à 1, m vaut 0 à 2,

$R^1$ représente un groupe $-C_p F_{2p+1}$, $-C_pF_{2p}X$, $-C_pF_{2p-1}XH$, pouvant être linéaire ou ramifié, p vaut 2 à 20, et X représente un atome d'halogène.

**2.** Procédé selon la revendication 1, caractérisé en ce qu'on utilise pour la copolymérisation 0,05 à 60 % en poids, sur la base de la quantité totale des monomères que l'on utilise, de monomères fluorés de formule Ia.

**3.** Procédé selon les revendications 1 et 2, caractérisé en ce qu'on utilise comme ester vinylique l'acétate de vinyle.

**4.** Procédé selon les revendications 1 à 3, caractérisé en ce qu'on utilise comme acides mono- et/ou dicarboxyliques à insaturation éthylénique, des composés de formule IIa :

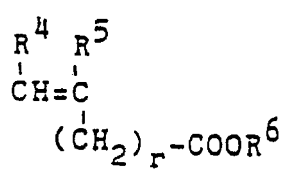

(IIa)

dans laquelle :
les symboles $R^4$ et $R^5$,qui peuvent être identiques ou différents , représentent chacun :

- $R^4$ un atome d'hydrogène, un groupe -COOH, un groupe alkyle en $C_1$ à $C_5$,
- $R^5$ un atome d'hydrogène un groupe $-CH_3$ ou -COOH,
- r vaut 0 à 5,
- $R^6$ représente un atome de H, un groupe $NH_4$, un atome de Na, K, Li.

**5.** Procédé selon les revendications 1 à 4, caractérisé en ce qu'on saponifie 40 à 100 moles % des motifs esters vinyliques en des motifs alcools vinyliques.

**6.** Procédé selon les revendications 1 à 5, caractérisé en ce qu'on conduit la copolymérisation en masse et/ou en solution.

**7.** Utilisation des copolymères fluorés, préparés selon les revendications 1 à 6, pour produire des feuilles.

**8.** Utilisation des copolymères fluorés, partiellement ou entièrement saponifiés, préparés selon les revendications 1 à 6, comme émulsifiants, colloïdes protecteurs, composants de colle, pour modifier en surface des substrats organiques et/ou minéraux, comme constituants de couches photosensibles et/ou dans des plaques d'impression photosensibles, pour produire des liquides hydrauliques aqueux ainsi que comme adjuvants dans la récupération tertiaire d'une huile de pétrole minérale.

**9.** Utilisation des copolymères fluorés, partiellement ou entièrement saponifiés et contenant des groupes carboxyles, préparés selon les revendications 1 à 6, comme produits pour le revêtement du papier ainsi que comme produits pour l'encollage.